# EUROPEAN PATENT APPLICATION

(11) **EP 4 661 005 A1**
(43) Date of publication of application: **10.12.2025**
(21) Application number: 24179891.7
(22) Date of filing: 04.06.2024
(51) Int. Cl.: G11C 7/18, G11C 11/412, G11C 11/418, H10B 10/00, G11C 8/12

(54) **A STATIC RANDOM ACCESS MEMORY DEVICE**

(71) Applicant: Imec VZW, 3001 Leuven (BE); Katholieke Universiteit Leuven KU Leuven Research & Development, 3000 Leuven (BE)
(72) Inventor: LIU, Hsiao-Hsuan, 3001 Leuven (BE); SALAHUDDIN, Shairfe Muhammad, 3010 Kessel Lo (BE)
(74) Representative: Lind Edlund Kenamets Intellectual Property AB

(57) **Abstract**

In an aspect there is provided an SRAM device comprising:
a plurality of hierarchical word line structures, HWLs, each comprising a global word line, GWL, and a plurality of local word lines, LWLs;
a plurality of hierarchical bit line structures, HBLs, each comprising a global bit line, GBL, a plurality of local bit lines, LBLs, a global bit line bar, GBLB, and a plurality of local bit line bars, LBLBs;
a plurality of local block column select lines, LBCSs;
a plurality of local block row select lines, LBRSs; and
an SRAM bit cell array comprising a plurality of bit cells arranged in a plurality of array rows and array columns, each array row associated with a respective HWL and each array column associated with a respective HBL,
wherein the SRAM bit cell array is partitioned into a plurality of local blocks, each local block associated with a respective LBCS and LBRS, and each comprising a respective subset of bit cells arranged in a plurality of local rows and local columns, each local row comprised in one of the array rows and connected to a respective LWL of the HWL associated with the array row, each local column comprised in one of the array columns and connected to a respective LBL and LBLB of the HBL associated with the array column;
for each local column of each local block, a first switch and a second switch, the first switch configured to selectively connect the LBL connected to the local column to its associated GBL, and the second switch configured to selectively connect the LBLB connected to the local column to its associated GBLB; and
for each local block, a respective logic circuit configured to individually assert a LWL connected to a local row of the local block in response to the LBCS and LBRS associated with the local block, and the GWL associated with the LWL being simultaneously asserted;
wherein each bit cell comprises cross-coupled inverters and pass gates, the inverters and pass gates comprising a first set of transistors arranged in a front-end-of-line, FEOL, structure of a die of the SRAM device; and
wherein the first and second switches and the logic circuits comprise a second set of transistors arranged in one or more device tiers over the FEOL structure.

## Description

### TECHNICAL FIELD

The present invention generally relates to a static random access memory device.

### BACKGROUND

Static Random Access Memory (SRAM) is a widely used memory technology, for instance in embedded systems and modern computing devices. A performance metric of interest in SRAM design is the Energy-Delay-Area-Product (EDAP). There is an on-going strive in the industry to provide SRAM designs enabling improved EDAP as technology scales.

### SUMMARY

A seemingly straightforward approach for improving the EDAP of an SRAM macro is to increase the size of its sub-arrays (i.e., increasing the number of rows and columns of bit cells of the sub-arrays), as this enables a reduced inter-sub-array interconnect routing overhead (e.g., H-tree routing overhead). However, for sub-arrays of a typical conventional design ("standard designs"), an increased size implies longer word lines and bit lines, which in turn increases resistive and capacitive losses of the sub-arrays and thus leads to degraded write margins. Hence, trying to increase the EDAP using this approach will eventually result in write failure problems.

It is thus an object of the present invention to provide approaches enabling SRAM implementations with improved EDAP. A further or alternative object is to enable larger SRAM sub-arrays, while mitigating loss of write margin.

According to an aspect of the present invention, there is provided an SRAM device comprising:
a plurality of hierarchical word line structures (hereinafter termed HWLs), each comprising a global word line(hereinafter termed GWL) and a plurality of local word lines (hereinafter termed LWLs);
a plurality of hierarchical bit line structures (hereinafter termed HBLs) each comprising a global bit line (hereinafter termed GBL), a plurality of local bit lines (hereinafter termed LBLs), a global bit line bar (hereinafter termed GBLB) and a plurality of local bit line bars (hereinafter termed LBLBs);
a plurality of local block column select lines (hereinafter termed LBCSs);
a plurality of local block row select lines (hereinafter termed LBRSs); and
an SRAM bit cell array comprising a plurality of bit cells arranged in a plurality of array rows and array columns, each array row associated with a respective HWL and each array column associated with a respective HBL,
   wherein the SRAM bit cell array is partitioned into a plurality of local blocks, each local block associated with a respective LBCS and LBRS, and each comprising a respective subset of bit cells arranged in a plurality of local rows and local columns, each local row comprised in one of the array rows and connected to a respective LWL of the HWL associated with the array row, each local column comprised in one of the array columns and connected to a respective LBL and LBLB of the HBL associated with the array column;
for each local column of each local block, a first switch and a second switch, the first switch configured to selectively connect the LBL connected to the local column to its associated GBL, and the second switch configured to selectively connect the LBLB connected to the local column to its associated GBLB; and
for each local block, a respective logic circuit configured to individually assert a LWL connected to a local row of the local block in response to the LBCS and LBRS associated with the local block, and the GWL associated with the LWL being simultaneously asserted;
wherein each bit cell comprises cross-coupled inverters and pass gates, the inverters and pass gates comprising a first set of transistors arranged in a front-end-of-line, FEOL, structure of a die of the SRAM device; and
wherein the first and second switches and the logic circuits comprise a second set of transistors arranged in one or more device tiers over the FEOL structure.

In some embodiments, the SRAM bit cell array, the associated HWLs, HBLs, LBCSs and LBRSs, and the additional logic provided for each local block of the SRAM bit cell array (i.e., first and second switches and logic circuits), may be comprised in a sub-array, the sub-array being one of a plurality of correspondingly configured sub-arrays of the SRAM device. The SRAM device may for example comprise or be configured as an SRAM macro comprising the plurality of sub-arrays. It is here to be noted that the term "SRAM bit cell array" refers to the arrangement of plural rows and columns of the bit cells, while the term "sub-array" (interchangeably, sub-array structure) refers to the overall array structure comprising the SRAM bit cell array, and the HWLs, HBLs, LBCSs, LBRSs and additional logic associated with the SRAM bit cell array.

In the present disclosure, the term "standard design" is used to refer to a design of an array structure (such as a sub-array of an SRAM macro) comprising an SRAM bit cell array, wherein each bit cell of each respective row is connected to a respective shared word line (WL) and each bit cell of each respective column is connected to a respective shared bit line (BL) and bit line bar (BLB). That is, each shared WL is common to all bit cells of its associated row and each shared BL and BLB are common to all bit cells of their associated column. This means that in the standard design, WLs, BL and BLBs associated with each row and column of bit cells are all connected to the bit cells, thus contributing to the parasitic resistive and capacitive (RC) losses of the WLs, BLs and BLBs.

In the present disclosure, the term "divided design" is used to refer to a design of an array structure (such as a sub-array of an SRAM macro) comprising, like the SRAM device of the present aspect:
a plurality of hierarchical word line structures (HWLs), each comprising a global word line (GWL) and a plurality of local word lines (LWLs);
a plurality of hierarchical bit line structures (HBLs) each comprising a global bit line (GBL), a plurality of local bit lines (LBLs), a global bit line bar (GBLB), and a plurality of local bit line bars (LBLBs);
a plurality of local block column select lines, LBCSs;
a plurality of local block row select lines, LBRSs; and
an SRAM bit cell array comprising a plurality of bit cells arranged in a plurality of array rows and array columns, each array row associated with a respective HWL and each array column associated with a respective HBL, wherein the SRAM bit cell array is
   partitioned into a plurality of local blocks, each local block associated with a respective LBCS and LBRS, and each comprising a respective subset of bit cells arranged in a plurality of local rows and local columns, each local row comprised in one of the array rows and connected to a respective LWL of the HWL associated with the array row, each local column comprised in
   one of the array columns and connected to a respective LBL and LBLB of the HBL associated with the array column;
for each local column of each local block, a first switch and a second switch, the first switch configured to selectively connect the LBL connected to the local column to its associated GBL, and the second switch configured to selectively connect the LBLB connected to the local column to its associated GBLB; and
for each local block, a respective logic circuit configured to individually assert a LWL connected to a local row of the local block in response to the LBCS and LBRS associated with the local block, and the GWL associated with the LWL being simultaneously asserted.

Hence, applying the divided design to a sub-array, additional logic (the switches and the logic circuits) is introduced into each sub-array of the SRAM device to enable local selection of local rows and local columns of each local block of the SRAM bit cell array of the sub-array. This allows reducing the effective RC of the word line and bit line circuitry, since the number of LWLs, LBLs and LBLBs which at any time need to be connected to the GWLs, GBLs, and GBLBs may be limited to those associated with the bit cell(s) to be accessed for read or write. The divided design thus enables an improved write margin, or conversely, increasing sub-array sizes while maintaining the write margin.

While the divided design would seem to offer a straightforward path towards improved EDAP, the local selection of bit cells however comes at the cost of a significant area penalty due to the additional logic.

As further realized by the inventors, in interconnect-dominated SRAM implementations, such as the divided design, the Power, Performance and Area (PPA) metric at the SRAM macro-level will be heavily influenced by the inter-sub-array interconnect, a factor intricately linked to the sub-array area. As the sub-array size increases, the increased sub-array area will cause higher inter-sub-array interconnect and macro area overheads. Therefore, the sub-array area penalty may, in fact, result in degraded macro-level EDAP. Although the divided design mitigates the write failure risk, it is hence not on its own an ideal design direction for PPA improvement and, in turn, macro-level EDAP improvement.

Based on these insights, the SRAM device according to the present aspect combines the divided design (e.g., in each sub-array) with arranging the transistors implementing the additional logic of the divided design in one or more device tiers above the FEOL structure comprising the transistors of the bit cells ("frontend transistors"). That is, the transistors of the divided design are "stacked" over the frontend transistors of the bit cells. The area penalty typically associated with the divided design (and hence the inter-sub-array interconnect and macro area overheads discussed above) may hence be avoided or at least mitigated. The SRAM device of the present aspect hence enables a sub-array implementation combining the divided design with stacking of the transistors of the additional logic over the frontend transistors to provide a synergistic effect of enabling increased sub-array sizes (and thus improved EDAP) while avoiding or mitigating a loss of write margin.

It is here noted that the term "additional logic" herein is used to refer specifically to the logic of the divided design provided for each local block, that is the switches for the selective connection of LBLs/LBLBs and GBLs/GBLBs, and the logic circuits for the individual assertion of the LWLs. This distinction is made since, as set out in the following, the SRAM device (e.g. each sub-array) may further comprise peripheral logic implementing functionality associated with the divided design (in particular LBCS and LBRS decoders) which is shared by (i.e., common to) all local blocks of the SRAM bit cell array. Since it is shared by the local blocks, the peripheral logic may be implemented by frontend transistors arranged in a peripheral region to the SRAM bit cell array instead of within the SRAM bit cell array. Hence, the frontend transistors of such peripheral logic may be arranged in the FEOL structure without any substantial area penalty to the SRAM bit cell array.

As will be further discussed in the below, the transistors of the additional logic may in some embodiments be arranged in a back-end-of-line (BEOL) interconnect structure of the SRAM device. In such embodiments, the transistors of the additional logic may be referred to as "backend transistors".

While reference in the above has been made mainly to a sub-array-based implementation, it is to be noted that the SRAM device of the present aspect may confer advantages also in other SRAM device implementations. For instance, the SRAM device may comprise an (e.g., a single) array or array structure comprising the SRAM bit cell array, the associated HWLs, HBLs, BLBs, LBCSs and LBRSs, and the additional logic provided for each local block of the SRAM bit cell array (i.e., the first and second switches and the logic circuits). Here, the combination of the divided design and the stacking of the transistors of the additional logic may facilitate an increased array size, improved EDAP, while avoiding or mitigating a loss of write margin.

In some embodiments, the logic circuit associated with each local block comprises:
a first logic gate having a first input connected to the associated LBCS and a second input connected to the associated LBRS, and,
for each LWL connected to a local row of the local block, a second logic gate having a first input connected to the GWL associated with the LWL, a second input connected to an output of the first logic gate, and an output connected to the LWL,
wherein each of the first and second logic gates is an AND gate or a NAND gate.

The logic circuits enabling the individual assertion of the LWLs of the local blocks may hence be implemented in an area efficient manner, using a relatively small number of AND or NAND gates and hence low transistor count.

In some embodiments, each first and second logic gate, and each first and second switch is arranged in a respective circuit cell of a plurality of circuit cells of the one or more device tiers, overlapping the local block,
wherein the first and second switches are arranged in a first subset of circuit cells, the first subset of circuit cells arranged in two cell rows and a number of cell columns corresponding to the number of local columns of the local block, and
wherein the first and second logic gates are arranged in a second subset of circuit cells, the second subset of circuit cells arranged in a number of cell rows, wherein at least one of the cell rows of the second subset comprises more than one second logic gate such that the number of cell rows of the second subset of circuit cells is less than the number of local rows of the local block.

By reducing the number of cell rows needed to accommodate the second logic gates, the second logic gates may be accommodated within the footprint of the local block (as seen along a column direction of the local block), even in implementations where a cell height of the circuit cells of the second logic gates exceeds a corresponding dimension of the bit cells. The second logic gates may hence be formed at relaxed pitches. Moreover, space may be created for accommodating the first and second cell rows of the first and second switches, such that the transistors of the additional logic (e.g. backend transistors) may fit within the footprint of the local block.

In some embodiments, the first and second switch are configured to turn on in response to the LBCS and LBRS associated with the local block being simultaneously asserted.

The LBCSs and LBRSs associated with each respective local block may thus further be used to control the first and second switches associated with the respective local block. Hence, the overall number of control signal lines needed to implement the divided design may be limited.

In some embodiments, a respective control input of the first and second switch is connected to the output of the first logic gate.

Hence, the logic circuit (more specifically the first AND or NAND gate) may have a double-function of facilitating individual assertion of a LWL and controlling the first and second switches.

In some embodiments, each first and second switch comprises a transmission gate.

This allows a GBL (or GBLB) to efficiently drive an associated LBL (or LBLB), and vice versa, using simple circuitry and a relatively small number of transistors.

In some embodiments, the second set of transistors is arranged within a footprint of the bit cells of the SRAM bit cell array.

The transistors of the additional logic associated with each respective local block need hence not extend outside, and thus not add to, the footprint of the SRAM bit cell array.

In some embodiments, the SRAM device further comprises peripheral logic comprising a LBCS decoder configured to selectively assert the LBCSs and a LBRS decoder configured to selectively assert the LBRSs, wherein the peripheral logic is implemented by a third set of transistors arranged in the FEOL structure of the die, in a peripheral region to the SRAM bit cell array.

The peripheral logic may thus be implemented by a third set of transistors, formed by frontend transistors of the FEOL structure of the die, and arranged in a peripheral region to the SRAM bit cell array. The peripheral region may in particular be adjacent to or adjoining the SRAM bit cell array.

In a sub-array-based implementation, the peripheral logic, including the LBCS decoder and the LBRS decoder, may be comprised in the sub-array. Consequently, each of a plurality of sub-arrays may comprise respective peripheral logic (a respective peripheral logic circuit), each comprising a respective LBCS decoder configured to selectively assert the LBCSs of the respective sub-array, and a respective LBRS decoder configured to selectively assert the LBRSs of the respective sub-array.

In some embodiments, the SRAM device further comprises a BEOL interconnect structure arranged on the FEOL structure and comprising the GWLs, LWLs, GBLs, LBLs, GBLBs, LBLBs, LBCSs and LBRSs, wherein the one or more device tiers comprising the second set of transistors are arranged in the BEOL interconnect structure.

The transistors of the additional logic may thus be formed by backend transistors of the BEOL interconnect structure of the die. The SRAM bit cell array, the associated HWLs, HBLs, LBCSs and LBRSs, and the additional logic of the divided design may thus be comprised in the FEOL and BEOL interconnect structures of a single die. This may contribute to an area efficient implementation, and comparably low routing complexity associated with the additional logic of the divided design. Moreover, this may enable a relatively tight pitch implementation of the additional logic, using relatively few BEOL routing layers and hence reduced RC overhead.

In some embodiments, the LWLs, LBLs and LBLBs are arranged below the one or more device tiers comprising the second set of transistors.

This may facilitate the signal routing as the backend transistors of the additional logic of the divided design will not block or interfere with vertical connections between the bit cells and the associated LWLs, LBLs and LBLBs.

In some embodiments, the GWLs, GBLs, GBLBs, LBCSs and LBRSs are arranged above the one more device tiers comprising the second set of transistors.

The backend transistors of the additional logic may thus be arranged between the layers of the BEOL interconnect structure comprising the LWLs, LBLs and LBLBs and the BEOL layers comprising the GWLs, GBLs, GBLBs, LBCSs and LBRSs. This may further facilitate signal routing and the connections between the GWLs, GBLs, GBLBs, LBCSs and LBRSs, and the LWLs, LBLs, and LBLBs.

In some embodiments, the second set of transistors are thin-film transistors.

Thin-film transistors (TFTs) enable realizing the backend transistors in a BEOL compatible manner. Suitable examples of TFTs include carbon nanotube (CNT) field-effect transistors (FETs) and 2D channel FETs.

In some embodiments, the die is a first die and the FEOL structure is a first FEOL structure, and the SRAM device further comprises a second die stacked on top of the first die and comprising a second FEOL structure, wherein the second set of transistors are arranged in the second FEOL structure.

Hence, instead of realizing the transistors of the additional logic as backend transistors in the BEOL interconnect structure of the first die comprising the frontend transistors of the SRAM bit cell array, the additional logic of the divided design may be realized by stacking and bonding the first die comprising the SRAM bit cell array and a second die comprising the additional logic. The transistors of the additional logic may hence be implemented as frontend transistors of the second FEOL structure of the second die. The SRAM device may hence be realized as a 3D integrated circuit (IC). This may facilitate fabrication of the additional logic in that mature single-die FEOL and BEOL fabrication technology may be utilized. Additionally, conventional 3D or bulk semiconductors (e.g., Si, SiGe or Ge) may be used as channel materials for the transistors of the additional logic, which may contribute to fast switching, high drive currents, device durability, etc.

In some embodiments, the SRAM device further comprises a first BEOL interconnect structure arranged on the first FEOL structure; and
a second BEOL interconnect structure arranged on the second FEOL structure;
wherein the second die is stacked on top of the first die, with the second BEOL structure facing the first BEOL structure, and
wherein, the first BEOL interconnect structure comprises the LWLs, the LBLs and the LBLBs, and wherein the second BEOL interconnect structure comprises the GWLs, GBLs, GBLBs, LBCSs and LBRSs.

The various lines associated with the bit cell array and the additional logic may hence be distributed between respective first and second BEOL interconnect structures of the first and second die. This may facilitate signal routing and limit routing overhead, since the transistors of the bit cells (the first set of transistors of the first FEOL structure) and the lines connected thereto (the LWLs, the LBLs and the LBLBs) may be comprised in a same die (the first die), and the transistors of the additional logic (the second set of transistors of the second FEOL structure) and the lines connected thereto (the GWLs, GBLs, GBLBs, LBCSs and LBRSs) may be comprised in a same die (the second die).

In some embodiments, the SRAM device further comprises an SRAM macro, wherein the SRAM bit cell array is comprised in one of a plurality of correspondingly configured SRAM sub-arrays of the SRAM macro. Accordingly, an SRAM device comprising an SRAM macro, may be provided, wherein the SRAM macro comprises a plurality of sub-arrays, each sub-array comprising:
a plurality of HWLs, each comprising a GWL and a plurality of LWLs;
a plurality of HBLs, each comprising a GBL, a plurality of LBLs, a GBLB, and a plurality of LBLBs;
a plurality of LBCSs;
a plurality of LBRSs; and
an SRAM bit cell array comprising a plurality of bit cells arranged in a plurality of array rows and array columns, each array row associated with a respective HWL of the sub-array and each array column associated with a respective HBL of the sub-array,
   wherein the SRAM bit cell array is partitioned into a plurality of local blocks, each local block associated with a respective LBCS and LBRS of the sub-array, and each comprising a respective subset of bit cells arranged in a plurality of local rows and local columns, each local row comprised in one of the array rows and connected to a respective LWL of the HWL associated with the array row, each local column comprised in one of the array columns and connected to a respective LBL and LBLB of the HBL associated with the array column;
for each local column of each local block of the SRAM bit cell array of the sub-array, a first switch and a second switch, the first switch configured to selectively connect the LBL connected to the local column to its associated GBL, and the second switch configured to selectively connect the LBLB connected to the local column to its associated GBLB; and
for each local block of the SRAM bit cell array of the sub-array, a respective logic circuit configured to individually assert a LWL (of the sub-array) connected to a local row of the local block in response to the LBCS and LBRS (of the sub-array) associated with the local block, and the GWL associated with the LWL being simultaneously asserted;
wherein each bit cell comprises cross-coupled inverters and pass gates, the inverters and pass gates comprising a first set of transistors arranged in a FEOL structure of the die of the SRAM device; and
wherein the first and second switches and the logic circuits comprise a second set of transistors arranged in one or more device tiers over the FEOL structure.

In line with the above discussion, the transistors of the additional logic of each sub-array may be formed by backend transistors of the BEOL structure of the die, or by frontend transistors of the second FEOL structure of the second die.

### BRIEF DESCRIPTION OF THE DRAWINGS

This and other aspects of the present invention will now be described in more detail, with reference to the appended drawings.
Fig. 1a-b schematically depict a top-down view (Fig. 1a) and a side view (Fig. 1b) of an SRAM device according to an example implementation.
Fig. 2a-e show example circuit and block diagrams of a sub-array of the SRAM device of Fig. 1a-b.
Fig. 3 shows an example floorplan of a bit cell of the SRAM device of Fig. 1a-b.
Fig. 4a-g show example layouts of a plurality of tiers or levels of the sub-array of the SRAM device of Fig. 1a-b.
Fig. 5a-b schematically depict a top-down view (Fig. 1a) and a side view (Fig. 1b) of an SRAM device according to a further example implementation.
Fig. 6 shows a block diagram of an SRAM device according to a further example implementation.

### DETAILED DESCRIPTION

In the following, a detailed description of example implementations of SRAM devices based on the so-called divided design will be provided with reference to the drawings. The drawings are only schematic and the relative dimensions of illustrated elements, such as layers or other structures, may be exaggerated and not drawn to scale. Rather the dimensions may be adapted for illustrational clarity and to facilitate understanding. When present in the figures, the indicated axes X, Y and Z point in a first horizontal direction, a second horizontal direction, and a vertical direction, respectively. As is apparent from the figures, the X direction and the Y direction respectively correspond to a row direction and a column direction of the respective bit cell arrays and array structures.

By the term "horizontal" is herein meant a direction parallel to a die of the SRAM device, i.e. parallel to a main surface (e.g., a frontside) of the die.

By the term "vertical" is herein meant a direction normal or transverse to the horizontal XY-plane, or equivalently, a direction normal or transverse to the die. Accordingly, terms indicating relative vertical arrangement of elements, such as "top", "upper", "bottom", "lower" and the like, are to be understood in relation to the vertical direction.

It is to be noted that when an element (e.g. an interconnect, a contact, a layer or other structure) is referred to as being "on" another element, it can be directly on the other element or on one or more intermediate elements on the other element. Conversely, when an element is referred to as being "directly on" another element, there is no intermediate element and the element is thus abutting (i.e., physically contacting) the other element.

It is further to be noted that terms such as "first" and "second" etc. with reference to elements (e.g. layers or other structures) or steps may be used herein as labels to facilitate distinguishing between different elements, and need not necessarily imply that such elements or steps are arranged or performed in that particular order, unless stated otherwise.

By the term "FEOL structure" is herein meant a portion of the SRAM device comprising an active layer of the die (i.e., comprising the active regions or patterns of the frontend transistors), a gate layer (i.e., comprising the gates of the frontend transistors), and a local contact or interconnect layer (i.e., comprising the source/drain (S/D) contacts of the frontend transistors). The active regions may comprise S/D regions and channel regions of the frontend transistors. The active layer may be formed in a semiconductor substrate of the die. While referred to as a single layer, the local contact layer may typically comprise (at least) two metal layers: a bottom layer ("contact-to-active" or "trench silicide") and a top or "plug" layer (e.g. of TiN, Co, Ru and/or W).

By the term "BEOL interconnect structure" (or simply "interconnect structure") is herein meant a vertical stack of interconnect layers, each comprising a dielectric layer embedding conductive elements (typically of metal) such as horizontally routed interconnects (conductive traces or lines) or vertically routed interconnects ("vias"). The term "metal routing layer" (or simply "routing layer") is herein used to refer to an interconnect layer comprising horizontally routed interconnects, while the term "via layer" is used to refer to an interconnect layer comprising vias. A via layer may thus provide vertical routing of signals between different metal routing layers, or between a routing layer and conductive elements of the FEOL structure.

For conciseness, the routing layers of the (BEOL) interconnect structure may in the following be denoted M0, M1, M2, M3, and so on, respectively, where the index indicates the position or level of the layer in the interconnect structure, counted from the die or FEOL structure. The M0 routing layer may be a bottom-most routing layer of the interconnect structure, i.e., the first routing layer over the FEOL structure. The via layers may in a corresponding manner be denoted V0, V1, V2, V3 and so on. The V0 layer may be a bottom-most via layer of the interconnect structure, i.e., the first via layer over the FEOL structure. The V0 layer may comprise gate vias and contact vias, landing on the gates and S/D contacts of the frontend transistors. For sake of completeness, it is noted that other labelling schemes for the layers of the interconnect structure exist. For instance, in some contexts, the M0 and V1 layers are instead denoted "MINT" and "VINT", respectively.

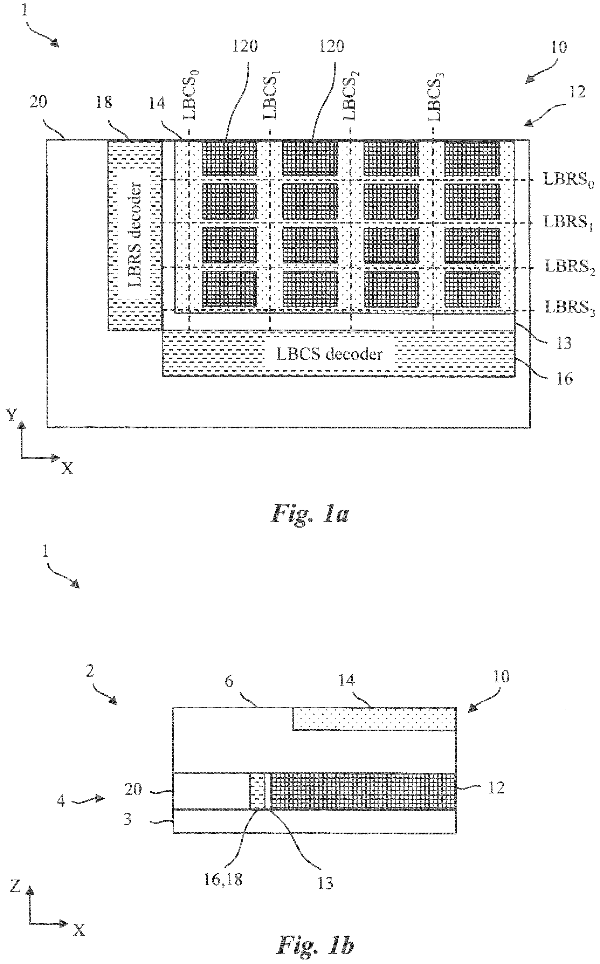

Fig. 1a-b schematically depict a top-down view (Fig. 1a) and a side view (Fig. 1b) of an SRAM device 1 comprising a sub-array 10 implementing a divided design in accordance with the present disclosure.

The SRAM device 1 comprises a die 2, a FEOL structure 4 and a BEOL interconnect structure 6. The die 2 may be a conventional semiconductor die or substrate, suitable for CMOS circuits and semiconductor device processing. The die 2 may as shown comprise a substrate 3, for instance a semiconductor substrate of Si, Ge or SiGe. Other nonlimiting examples include a silicon-on-insulator (SOI) substrate, a GeOI substrate or a SiGeOI substrate.

While Fig. 1a-b shows one sub-array 10, the sub-array 10 may be one of a plurality of correspondingly configured sub-arrays of the SRAM device 1. Accordingly, when reference in the following is made to sub-array 10, it is to be understood that the discussion may apply correspondingly to each sub-array of the SRAM device 1.

The sub-array 10 comprises an SRAM bit cell array 12. The SRAM bit cell array 12 comprises a plurality of SRAM bit cells arranged in a plurality of array rows (extending in the X direction) and array columns (extending in the Y direction).

The bit cell array 12 is in accordance with the divided design partitioned or divided into a plurality of respective local blocks, commonly referenced 120. The local blocks are arranged in a plurality of block rows (extending in the X direction) and a plurality of block columns (extending in the Y direction). Each local block 120 comprises a respective subset of the bit cells of the bit cell array 12. The bit cells of each local block 120 are arranged in a plurality of local rows (extending in the X direction) and local columns (extending in the Y direction). Each local row of a respective local block 120 is comprised in (i.e., belongs to) a respective array row of the bit cell array 12, and each local column of the local block 120 is comprised in (i.e., belongs to) a respective array column of the bit cell array 12.

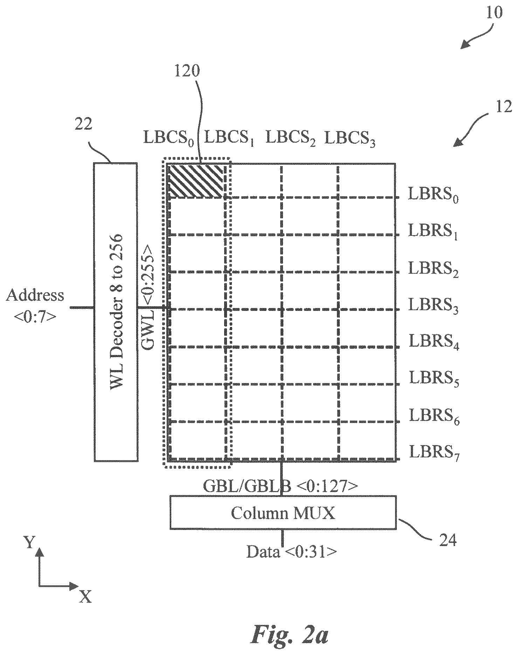

As will be further discussed with reference to Fig. 2a-c below, the sub-array 10 comprises a plurality of hierarchical word line structures (HWLs) and a plurality of hierarchical bit line structures (HBLs). Each HWL comprises a global word line (GWL) and a plurality of local word lines (LWLs). Each HBL comprises a global bit line (GBL) and a plurality of local bit lines (LBLs), a global bit line bar (GBLB) and a plurality of local bit line bars (LBLBs). The sub-array 10 further comprises a plurality of local block column select lines (LBCSs) and local block row select line (LBRSs). The HWLs, HBLs, LBCSs and LBRSs are arranged in the interconnect structure 6, e.g., in one or more interconnect layers thereof. To not overly obscure Fig. 1-b, only a subset of these lines (LBCS₀₋₃ and LBRS₀₋₃) are expressly indicated.

Each array row of the bit cell array 12 is associated with a respective HWL and each array column is associated with a respective hierarchical bit line structure HBL. That is, the sub-array 10 comprises a respective HWL for each array row, and a respective HBLs for each array column, such that each HWL is associated with a respective array row and each HBL is associated with a respective array column. Further, each local block 120 is associated with a respective LBCS and LBRS. That is, the sub-array 10 comprises a respective LBCS for each block column, and a respective LBRS for each block row, such that each LBCS is associated with (e.g., connected to) a respective block column, and each LBRS is associated with a respective block row. Further, each local row of each local block 120 is connected to a respective LWL of the HWL associated with its array row, and each local column of each local block 120 is connected to (i.e., between) a respective LBL and LBLB of the HBL associated with its array column.

Each bit cell of the bit cell array 12 comprises cross-coupled inverters and pass gates. The bit cells may in particular be implemented as 6-transistor (6T) bit cells. The transistors of the bit cells define a first set of transistors arranged in the FEOL structure 4. The transistors implementing the inverters and pass gates of the bit cells are thus frontend transistors. The frontend transistors may be NMOSFETs and PMOSFETs. The frontend transistors may typically be realized as horizontal channel FETs, such as FinFETs, nanosheet FETs or nanowire FETs, having channel regions and S/D regions formed on or in an active layer of the die 2. The channel regions and S/D regions may be formed by any conventional suitable semiconductor materials such as Si, Ge or combinations thereof.

To implement individual and local selection of the local rows and local columns of bit cells of the local blocks 120, the sub-array 10 comprises additional logic 14. Instead of arranging the transistors of the additional logic 14 in a respective periphery to each local block 120, the transistors of the additional logic 14 (defining a second set of transistors) are here realized as backend transistors arranged in one more device tiers 14 within the interconnect structure 14. Any area penalty associated with the additional logic 14 of the divided design may hence be minimized. In particular, the backend transistors of the additional logic 14 may be arranged within a footprint of the bit cell array 12.

The backend transistors may be realized as TFTs, such as CNT FETs and/or 2D channel FETs. A CNT FET is a transistor device comprising a channel structure of one or more CNTs. A 2D channel FET is a transistor device comprising a channel structure of a 2D semiconductor. Examples of 2D semiconductors include transition metal dichalcogenides (TMDs), IGZO, IGO, and other suitable 2D semiconductors conventionally used to realize backend transistors. Fabrication of the backend transistors may comprise process techniques which per se are known in the art, such as deposition of channel material on top of an interconnect layer of the interconnect structure 6, patterning and doping the channel material to form channel regions and S/D regions, gate stack and S/D contact deposition, etc. After completing formation of the backend transistors, further interconnect layers of the interconnect structure 6 may be processed on top of backend transistors, e.g., to form the interconnects of the additional logic 14 and connect the additional logic 14 to appropriate parts of the sub-array 10. Fabrication techniques which may be used to form the backend transistors include 3D sequential techniques (sometimes referred to as monolithic 3D integration) involving blanket active layer transfer onto a prefabricated FEOL structure 1 and (lower part of) interconnect structure 6. In a monolithic 3D integration, the backend transistors need to be fabricated at a low thermal budget to avoid degradation of the frontend transistors of the FEOL structure 4, typically below 500 °C. In other words, the backend transistors may advantageously be BEOL-compatible devices. Details concerning fabrication and integration of backend transistors are per se known in the art and will hence not be further described herein.

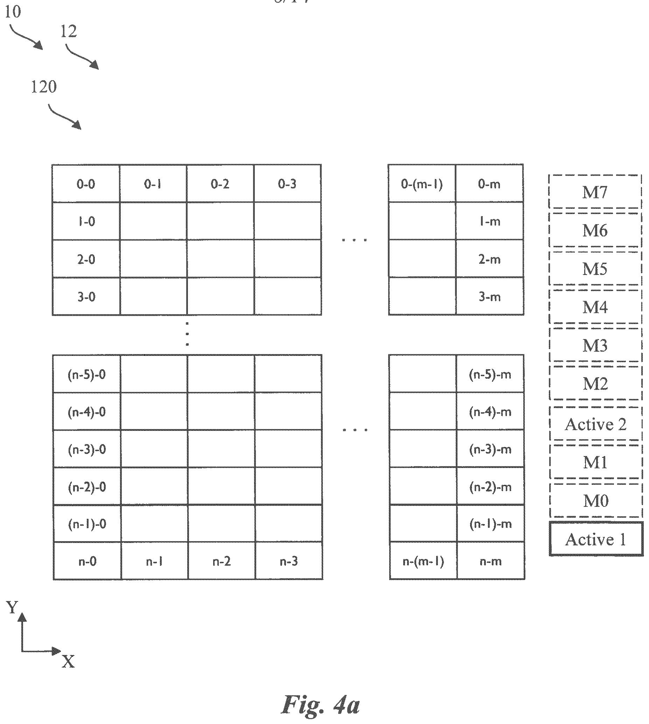

Example implementations of the additional logic 14 are discussed below with reference to Fig. 2a-c. Further, example implementations of the interconnect structure 6 and the device tiers 14 are discussed below with reference to Fig. 4a-g.

The sub-array 10 further comprises peripheral logic arranged in a peripheral region to the bit cell array 12, i.e., in a peripheral region of the sub-array 10 ("sub-array periphery"). The peripheral logic is shared by the local blocks 120 of the bit cell array 12. The peripheral logic comprises an LBCS decoder 16 connected to the LBCSs and configured to selectively assert any one of the LBCSs responsive to a column address. The peripheral logic further comprises an LBRS decoder 18 connected to the LBRSs and configured to selectively assert any one of the LBCSs responsive to a row address. As may be appreciated more fully from the below discussion of Fig. 2a-c, the LBCS decoder 16 and the LBRS decoder 18 may thus together facilitate individual selection of the local block 120 connected to the asserted pair of LBRS and LBCS. The transistors of the peripheral logic (defining a third set of transistors) are implemented as frontend transistors arranged in the FEOL structure 4, in the peripheral region to the bit cell array 12. The third set of transistors may like the frontend transistors of the bit cells be NMOSFETs and PMOSFETs, and be implemented in a corresponding manner.

The sub-array 10 may further comprise peripheral logic not related specifically to the divided design, as per se is known in the art, such as a timing controller, address flip-flops, a word line decoder, write drivers, precharge circuitry, sense amplifiers, etc. Such further peripheral logic is in Fig. 1a-b collectively indicated by a schematic peripheral logic block 20.

The peripheral logic 16, 18, 20 and the bit cell array 12 may as shown be separated by an isolation gap or isolation region 13.

Example circuit implementations of the sub-array 10 will now be discussed with reference to Fig. 2a-d, with particular attention to the additional logic 14. As would be appreciated by the skilled person, the specific array dimensions, the number of local blocks and associated LBCSs and LBRSs discussed above and in the below are merely provided by way of example, and other dimensions are also possible.

Fig. 2a shows the bit cell array 12 configured as a 128-C by 256-R array (i.e., 128 array columns and 256 array rows). Hence, there are in the illustrated example 256 GWLs (GWL₀₋₂₅₅) and 128 pairs of GBLs and GBLBs (GBL₀₋₁₂₇ and GBLB₀₋₁₂₇).

The bit cell array 12 is partitioned into 32 local blocks 120 arranged in 8 block rows and 4 block columns. That is, the number of local blocks 120 in the row direction X (equivalent to the WL direction) is 4 and the number of local blocks 120 in the column direction Y (equivalent to the BL direction) is 8. Hence, each local block 120 comprises 32 by 32 bit cells.

Accordingly, the sub-array 10 comprises as shown 4 LBCSs (LBCS₀₋₃) and 8 LBRSs (LBRS₀₋₇). Each LBRS₀₋₇ extends in the row direction X and each LBCS₀₋₃ extends in the column direction Y. Each local block 120 is connected to a respective pair of a LBCS and a LBRS. LBRS₀₋₇ and LBCS₀₋₃ are respectively connected to the LBRS and LBCS decoders 16, 18 shown in Fig. 1a but for simplicity omitted from Fig. 2a.

The sub-array 10 (e.g., the peripheral logic 20 of Fig. 1a-b) further comprises a WL decoder 22 and a column multiplexer (MUX) 24.

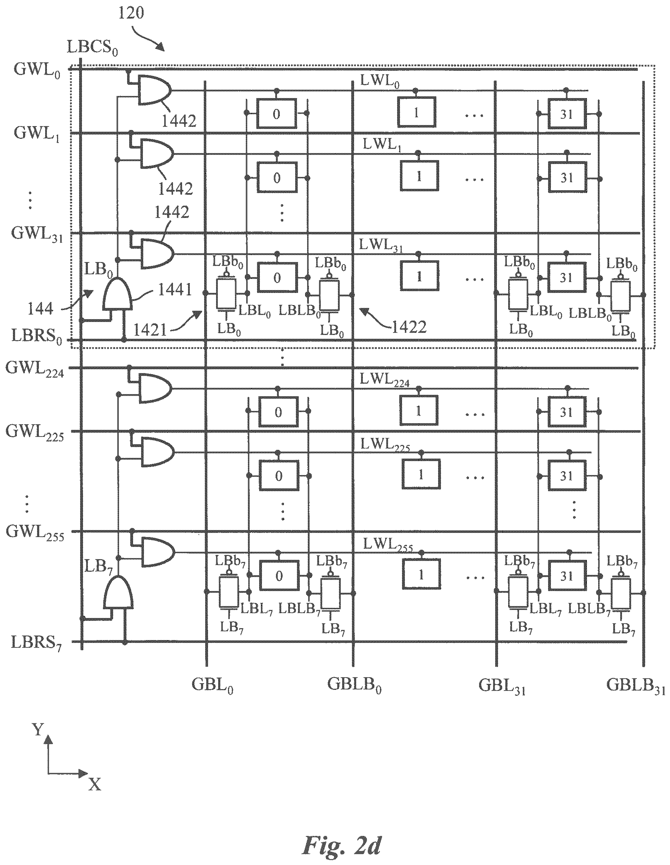

The WL decoder 22 is connected to each GWL₀₋₂₅₅ of the sub-array 10 and configured to selectively enable any one thereof responsive to a row address (e.g., an 8-bit address). Hence, while the WL decoder 22 is configured to individually assert any one of the GWLs (GWL₀₋₂₅₅) of the sub-array 10, the LBCS decoder 16 and the LBRS decoder 18 are configured to individually assert any pair of an LBCS (LBCS₀₋₃) and an LBRS (LBRS₀₋₇) of the sub-array 10. As will be further explained with reference to Fig. 2d, this in turn enables individual assertion of any one of the LWLs associated with any one of the local blocks of the sub-array 10. The row address to the WL decoder 22, and the addresses to the LBCS decoder 16 and the LBRS decoder 18 may be provided from one or more address flip-flops (e.g., D flip-flops) of the peripheral logic 20, as per se is known in the art.

The peripheral logic further comprises an LBRS decoder 18 connected to the LBRSs and configured to selectively assert any one of the LBCSs responsive to a row address. As may be appreciated more fully from the below discussion of Fig. 2a-c, the LBCS decoder 16 and the LBRS decoder 18 may thus together facilitate individual selection of the local block 120 connected to the asserted pair of LBRS and LBCS.

The column MUX 24 is connected to each GBL and GBLB of the sub-array 10 and configured to selectively connect any one pair thereof, or groups of pairs thereof, to the writer driver (in case of writing to the bit cell array 12) or the sense amplifier (in case of reading from the bit cell array 12). The column MUX 24 may be responsive to an enabling signal, e.g., from a timing control block of the peripheral logic 20. In the illustrated example, the column MUX 24 is a 4 input-to-1 output MUX, meaning that signals may be directed to/from four respective groups of GBLs and GBLBs (e.g., typically the set of GBLs and GBLBs associated with each local block of a local block row) from/to the writer driver/sense amplifier. However, this is just an example, and other configurations are also possible, such as a 8-to-1 or 16-to-1 column MUX 24, to name a few.

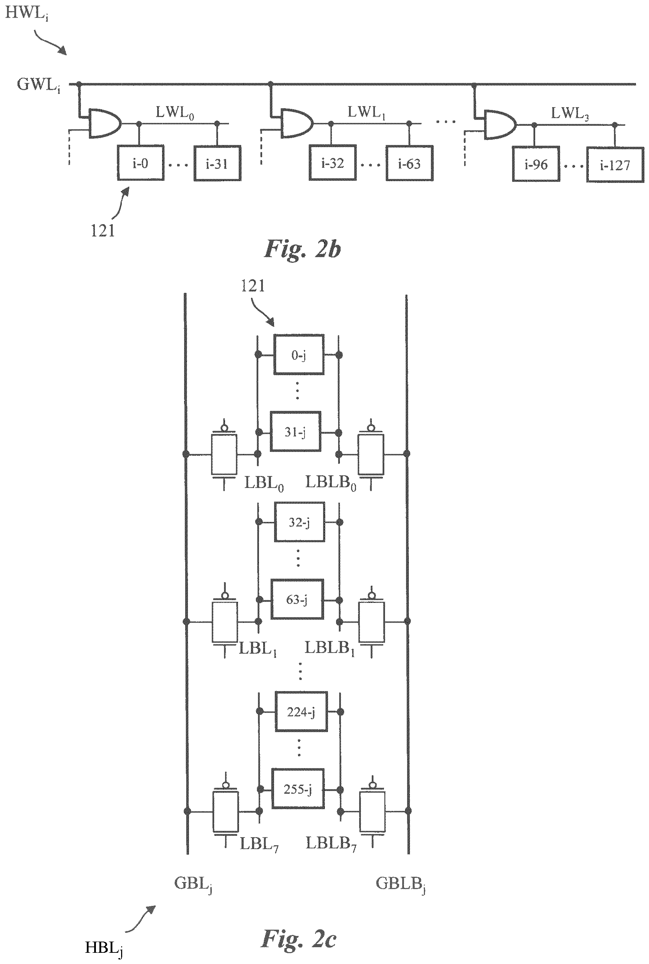

Fig. 2b-c schematically shows the hierarchical configuration of the WLs and BLs of the sub-array 10. In the figures, each bit cell 121 is schematically by a rectangular box indexed i-j, where is the index of the array row of the bit cell and j is the index of the array column of the bit cell. For the depicted array dimension, it follows that i=0...255 and j=0...127.

With reference to Fig. 2b, each hierarchical word line HWLᵢ comprises a GWLᵢ configured as a common (i.e., "global") word line for all bit cells of its associated array row i. Further, each HWLᵢ comprises a respective LWL for each local row of the array row i, i.e., LWL₀, LWL₁ ..., LWL₃. Hence, each HWLᵢ comprises a respective LWL for each block column of local blocks 120. The number of LWLs of each HWLᵢ corresponds to the number of local blocks 120 per local block row (i.e., 4 in the illustrated example). Each LWL₀₋₃ is connected to the bit cells of its associated local row, i.e., LWL₀ is connected to bit cells i-0 to i-31, LWL₁ is connected to bit cells i-32 to i-63, and so on.

With reference to Fig. 2c, each hierarchical bit line HBLⱼ comprises a GBLⱼ and a GBLBⱼ configured as a common (i.e., "global") bit line and bit line bar for all bit cells of its associated array column j. Further, each HBLⱼ comprises a respective LBL and LBLB for each local column of the array column j, i.e., LBL₀/LBLB₀, LBL₁/LBLB₁, ... LBL₇/LBLB₇.

Hence, each HBLᵢ comprises a respective LBL and LBLB for each block row of local blocks 120. The number of LBLs/LBLBs of each HBLⱼ corresponds to the number of local blocks 120 per local block column (i.e., 8 in the illustrated example). Each LBL₀₋₇/LBLB₀₋₇ is connected to the bit cells of its associated local column, i.e., LBL₀/LBLB₀ is connected to bit cells 0-j to 31-j, LBL₁/LBLB₁ is connected to bit cells 32-j to 63-j, and so on.

Fig. 2d shows in further detail a circuit diagram representing the highlighted column of local blocks in Fig. 2a, comprising the local block 120 (i.e., the local block 120 connected to LBCS₀ and LBRS₀). It is to be understood that each further local block of the bit cell array 12 has a corresponding configuration.

In Fig. 2d, each bit cell 121 is like in Fig. 2b-c indicated by a respective box. For conciseness, each bit cell is referenced by the single index j (the array column index of the bit cell) since its row position is apparent from its associated GWL and LWL.

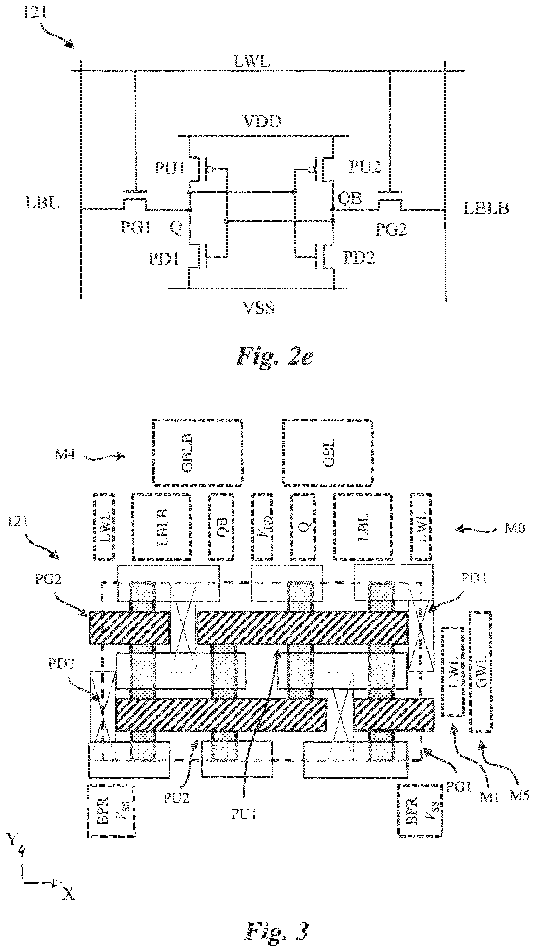

Fig. 2e shows the circuit layout of the bit cells 121, when implemented as a 6-transistor (6T) cell. LBL and LBLB denotes the bit line and bit line bar associated with the bit cell 121. LWL denotes the word line associated with the bit cell 121. PG1 and PG2 denote first and second pass gates or pass transistors of the bit cell 121. PU1 and PU2 denote first and second pull-up transistors of the bit cell 121. PU1 and PU2 are coupled to the pull-up supply voltage or power rail VDD. PD1 and PD2 denote first and second pull-down transistors of the bit cell 121. PD1 and PD2 are coupled to the pull-down supply voltage or power rail denoted VSS.

VDD and VSS may as per se is known in the art be arranged in the interconnect structure 6, as buried power rails embedded in the substrate 3 of the die 2, or as backside power rails of a backside power distribution network of the die 2.

PD1 and PU1 are configured as a first inverter PD1/PU1. PD2 and PU2 are configured as a second inverter PD2/PU2. The first and second inverters PD1/PU1 and PD2/PU2 are cross-coupled to each other. The first inverter PD1/PU1 and the first pass gate PG1 are comprised in a first half cell of the bit cell 121 and are interconnected to define a first storage node Q of the first half cell. The second inverter PD2/PU2 and the second pass gate PG2 are comprised in a second half cell of the bit cell 121 and are interconnected to define a second storage node QB of the first half cell.

As mentioned above, the sub-array 10 comprises additional logic 14 configured to implement individual and local selection of the local rows and local columns of bit cells of the local blocks 120. Fig. 2d shows an example implementation of the portion of the additional logic associated with the local block 120. The additional logic comprises first and second switches 1421, 1422 and a logic circuit 144. Corresponding first and second switches and logic circuits are as shown provided for each further local block of the local block column, and also for each further local block of the sub-array 10.

The logic circuit 144 is configured to individually assert any one of the LWLs (e.g., LWL₀₋₃₁) in response to the LBCS and LBRS associated with the local block 120 (e.g., LBCS₀ and LBRS₀), and the GWL (e.g., LWL₀₋₃₁) associated with the LWL to be asserted being simultaneously asserted. As mentioned above, the LBCSs and LBRSs are asserted by the LBCS decoder 16 and the LBRS decoder 18, respectively. The GWLs are asserted by the WL decoder 22. By "asserting" a line is herein meant that the line is "enabled" or "activated", typically by setting or biasing the line to an "enable" or "active" voltage of a predetermined level. The illustrated example is an "active high" implementation, meaning that active voltage is a logical high ("1"). However, as would be realized by the skilled person, with corresponding adaption of the circuitry, an "active low" implementation would also be possible, meaning the active voltage is a logical low ("0").

The logic circuit 144 comprises as shown a first AND gate 1441 having a first input connected to the associated LBCS (LBCS₀) and a second input connected to the associated LBRS (LBRS₀). The output LB₀ of the first AND gate 1441 will thus be asserted in response to (i.e. only) when LBCS₀ and LBRS₀ are simultaneously asserted. That is, when LBCS₀ and LBRS₀ are asserted, the output LB₀ of the first AND gate 1441 becomes active (e.g., "1"). The logic circuit 144 further comprises, for each a local row i=0...31 of the local block 120, a respective second AND gate (collectively referenced 1442) having a first input connected to the GWL (GWLᵢ) associated with the LWL (LWLᵢ) connected to the local row i, a second input connected to an output of the first AND gate, and an output connected to LWLᵢ. Thereby, the output of each respective second AND gate 1442 (and hence the corresponding LWLᵢ connected to the output of the respective second AND gate) will be asserted in response to LBCS₀, LBRS₀ and GWLᵢ being simultaneously asserted. Hence, the logic circuit 144 facilitates an individual selection of any LWLᵢ of the local block 120.

Now turning to the first and second switches 1421, 1422, each switch may as shown be implemented by a respective transmission gate (TG), each comprising a pair of complementary transistors (an NMOSFET and a PMOSFET connected in parallel). The state of each switch / TG 1421, 1422 is as shown controlled by (i.e., responsive to) the output LB₀ of the first AND gate 1441. Hence, the switches 1421, 1422 are configured to turn on in response to LBCS₀ and LBRS₀ being simultaneously asserted. To illustrate, when LBCS₀ and LBRS₀ are both asserted, the output LB₀ of the first AND gate 1441 becomes active (e.g., "1") wherein, in response, the control inputs of the first and second switches 1421, 1422 are asserted and the switches 1421, 1422 are turned on, i.e., closed. In further detail, as the control signal to the gate of the PMOSFET of each TG is the logical complement to signal input to the control input of the TG (e.g., LBb₀ which is the logical complement to LB₀), setting LB₀ to a logical high turns on both the PMOSFET and the NMOSFET of the TG. By configuring the switches 1421, 1422 to be responsive to LBCS₀ and LBRS₀ in this manner obviates the need for separate control lines and control circuitry for controlling the GBL/LBL and GBLB/LBLB connections.

In summary, to access (for read or write) a selected bit cell of a local block of the sub-array 10 (e.g., bit cell 0 connected to LWL₃₁ of the local block 120), the LBCS and LBRS connected to the local block comprising the selected bit cell, and the GWL associated with the array row comprising the selected bit cell (e.g., LBCS₀, LBRS₀ and GWL₃₁) may be asserted, such that in turn the LWL connected to the selected bit cell is asserted (e.g., LWL₃₁). In turn, the first and second switches respectively connected to the LBL and LBLB connected to the selected bit cell will be closed such that the LBL and LBLB are connected to their associated GBL and GBLB (e.g., switches 1421, 1422 connected to LBL₀ and LBLB₀ are closed such that LBL₀ is connected to GBL₀ and LBLB₀ is connected to GBLB₀). As per se is known in the art, both read and write operations may comprise precharging. In the sub-array 10 it is specifically the GBL and GBLB associated with the selected bit cell which may be precharged (e.g., using precharge circuitry of the peripheral logic block 20 of Fig. 1a-b). During read, the stored state may be read-out by sensing the currents or voltages resulting in the (precharged) GBL and GBLB upon accessing the selected bit cell (e.g., using a sense amplifier of the peripheral logic block 20). During write, one or the other of the (precharged) GBL and GLBLB may be driven low depending on the logical states to be written to the storage nodes Q, QB of the selected bit cell (e.g., using a write driver of the peripheral logic block 20 of Fig. 1a-b).

While in the illustrated example, the logic circuit 144 is implemented by a set of interconnected AND gates 1441, 1442, other implementations providing an equivalent function are also possible as would be realized by those skilled in the art. For instance, the AND gates 1441, 1442 may in an active low implementation be replaced by corresponding NAND gates. Other implementations of the first and second switches 1421, 1422 are also possible. For instance, an LBL (or LBLB) may be switchably connected to its associated GBL (or GBLB) by a single transistor switch (e.g., an NMOSFET like the pass gates of the bit cells 121).

Fig. 3 is a schematic depiction of a floorplan of a bit cell 121 according to an example implementation. The same reference signs are used to denote the respective transistors of the bit cell 121 as in Fig. 2e. The rectangles with the dotted fill pattern oriented in the Y direction represent the active regions of the transistors. The rectangles with the diagonal pattern oriented in the X direction represent the gates of the transistors. The transparent rectangles oriented in the X direction represent the S/D contacts of the transistors (i.e., of the local contact level of the FEOL structure 4). The crossed-out regions indicate gate cuts. The rectangular boxes adjacent the bit cell area indicate routing tracks for the lines associated with the bit cell 12, the corresponding reference signs indicating their respective locations (i.e., layers) in the interconnect structure 6. While shown as BPRs, the depicted bit cell 121 configuration is also compatible with the VSS power rails being arranged in backside routing tracks.

Fig. 4a-g schematically show example layouts of the levels of the sub-array of sub-array 10 which may be used together with the bit cell floorplan shown in Fig. 3. For simplicity, the peripheral logic of the sub-array 10 has been omitted from the following drawings. The right hand-side of each figure includes a legend indicating the top layer or layers shown in the respective view.

Fig. 4a shows the bit cell array 12 wherein each bit cell is represented by a respective box labelled i-j, where, like in the above discussion, i is the index of its array row and j is the index of its array column. Fig. 4a more specifically shows a single local block of the bit cell array 12, here shown as comprising an (m+1) local columns by (n+1) local rows. As previously discussed, the transistors of the bit cells of the bit cell array 12 are comprised in the FEOL structure 4, in Fig. 4a denoted "Active 1" to signify that the bit cell transistors are comprised in the first active layer of the die 2.

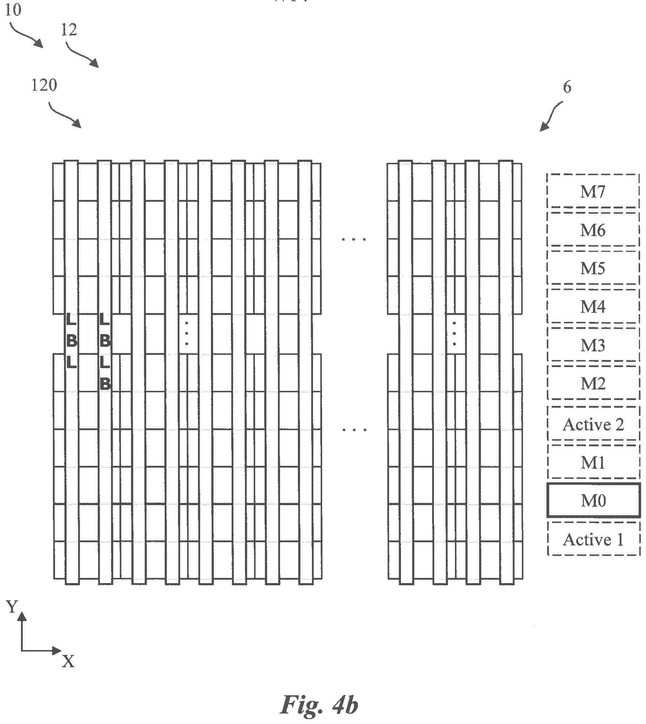

Fig. 4b shows the LBLs and LBLBs arranged in the M0 layer. The LBLs and LBLBs extend in parallel in the Y direction. Each local column of bit cells is overlapped by a respective pair of an LBL and an LBLB. The LBLs and LBLBs connect to the access ports (S/D contacts) of the pass gates PG1, PG2 of the bit cells, e.g., by contact vias of the V0 layer.

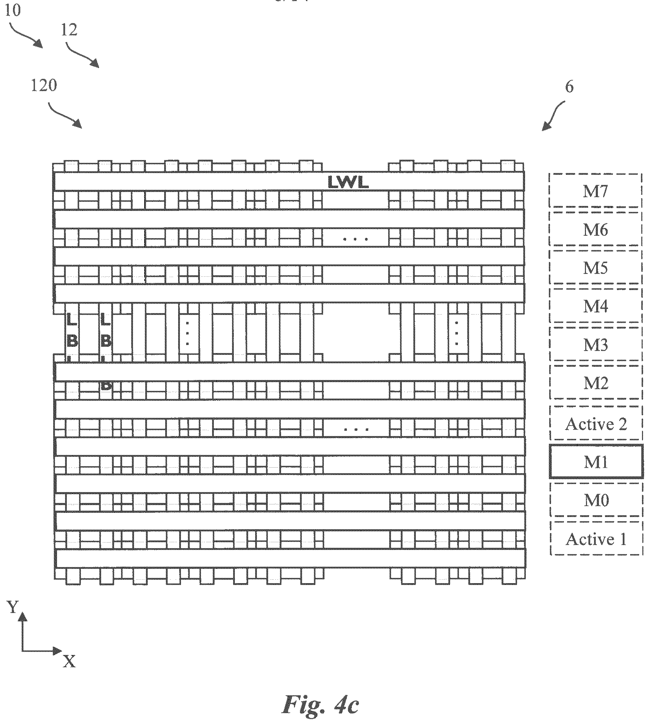

Fig. 4c shows the LWLs arranged in the M1 layer. The LWLs extend in parallel in the X direction. Each local row of bit cells is overlapped by a respective LWL. The LWLs connect to the gates of the pass gates PG1, PG2 of the bit cells, e.g., by gate vias of the V0 layer.

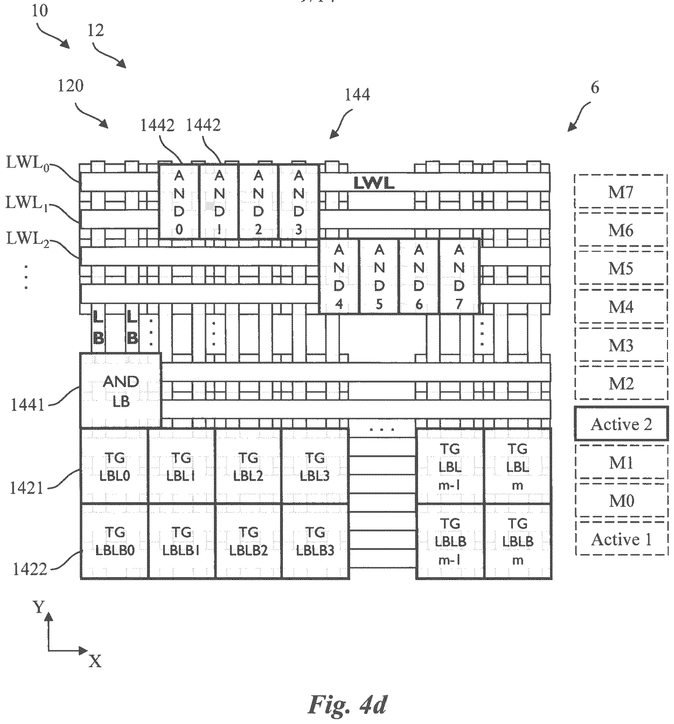

Fig. 4d shows the device tier (second active layer of the die 2) "Active 2" comprising the first and second logic gates 1441, 1442 of the logic circuit 144 (in the illustrated example AND gates) and the switches 1421, 1422 (in the illustrated example TGs). Each switch 1421, 1422 and each logic gate 1441, 1442 defines (i.e., is arranged in) a respective circuit cell of the Active 2 layer. The rectangular outline surrounding each block ("AND LB", "AND 0-7", "TG LBL0", "TG LBLB0", "TGLBL1", "TG LBLB1", etc.) indicate the boundaries or edges of each respective circuit cell.

While the Active 2 layer is schematically shown as a single layer, it is to be noted that the backend transistors of the additional logic 14 as indicated above may comprise an active semiconductor layer (i.e., comprising the active regions or patterns of the backend transistors, i.e., the S/D regions and channel regions), a gate layer (i.e., comprising the gates of the backend transistors), and, optionally, a local contact or interconnect layer (i.e., comprising the S/D contacts of the backend transistors). The backend transistors of the Active 2 layer may be interconnected by the local contact layer, and/or by interconnect layers of the interconnect structure 6, such as the V2 and M2 layers etc.

Further, the Active 2 layer may be arranged on top of a further via layer which may be termed "backside" (BS) via layer, as it is arranged on a "backside" of (i.e., underneath) the Active 2 layer. The BS via layer may interconnect the Active 2 layer and the next routing layer below (e.g., M1 or M2a, discussed below).

Although not shown in Fig. 4d, the interconnect structure 6 may comprise an additional routing layer between the M1 layer and the Active 2 layer. While this routing layer, if present, would be denoted M2 adopting the above introduced indexing of the routing layers (which counts from the FEOL structure 4), it will in the following be denoted M2a to distinguish from the previously introduced M2 layer over the Active 2 layer. The M2a layer may in particular comprise lines (and routing tracks) extending in parallel in the Y direction. Where the M2a layer is present, a corresponding additional via layer V2a (to distinguish from the previously introduced V2 layer over the Active 2 layer) may be provided between the M1 and M2a layers.

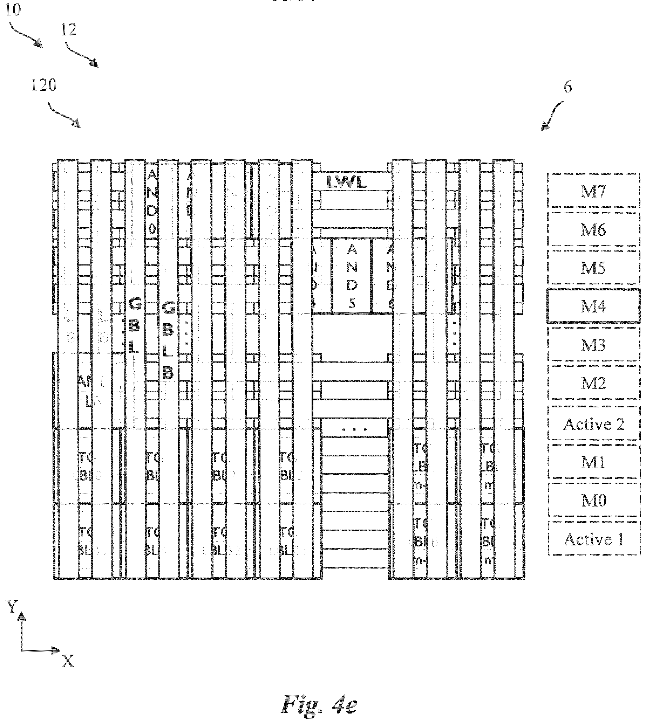

Fig. 4e shows the GBLs and GBLBs arranged in the M4 layer. The GBLs and GBLBs extend in parallel in the Y direction. Each local column of bit cells is overlapped by a respective pair of an GBL and an GBLB. In particular, as shown, each GBL may overlap a respective LBL and each GBLB may overlap a respective LBLB.

Although not shown in Fig. 4a-g, the M2 and M3 layers between the Active 2 layer and the M4 layer may comprise respective sets of lines. The lines of the M2 layer may extend in parallel in the Y direction. The lines of the M3 layer may extend in parallel in the X direction. Providing two layers of transversely oriented lines between the M4 layer and the Active 2 layer may confer a greater flexibility in routing signals between the GBLs/GBLBs and the switches 1421, 1422 of the Active 2 layer. However, the main benefit of the M2 and M3 layers is that they may facilitate signal routing between the first and second logic gates 1441, 1442, and between the first logic gate 1441 and the switches 1421, 1422, further discussed below.

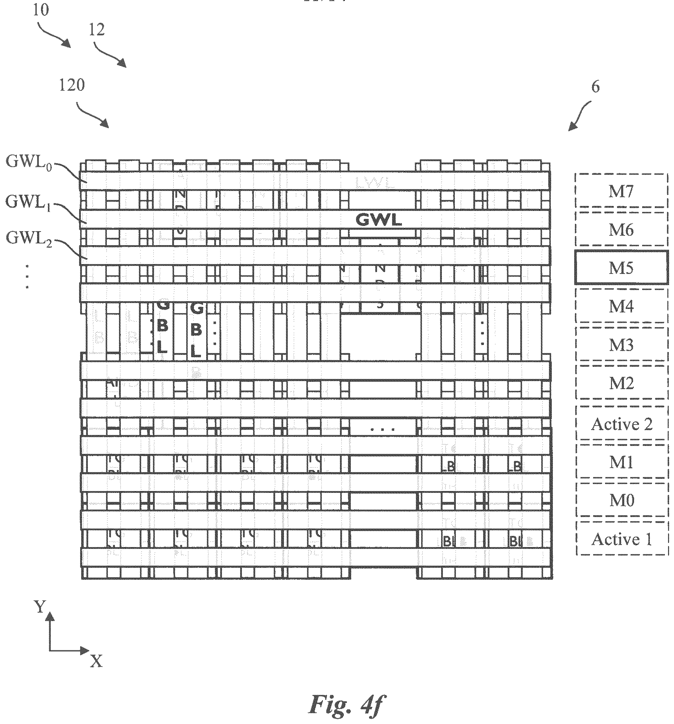

Fig. 4f shows the GWLs arranged in the M5 layer. The GWLs extend in parallel in the X direction. Each local row of bit cells is overlapped by a respective LWL. In particular, each GWL may overlap a respective LWL.

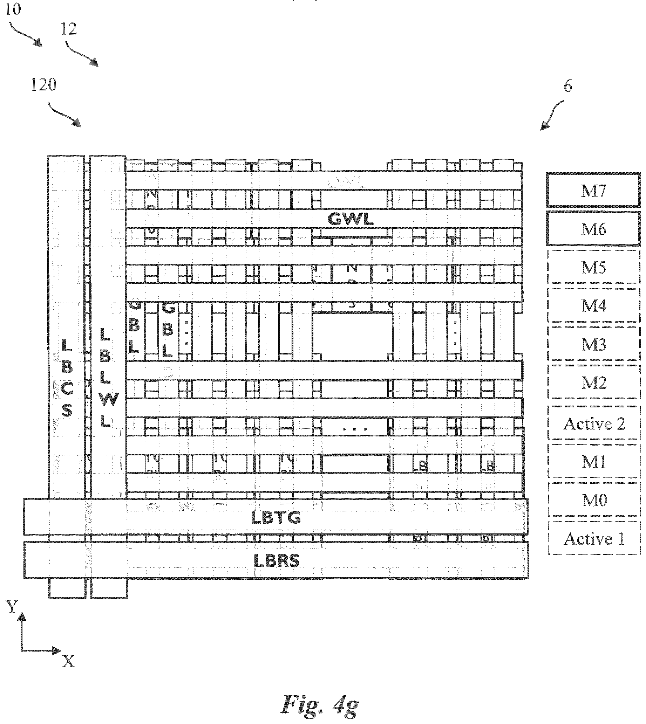

Fig. 4g shows the LBCS and the LBRS associated with the local block 120. The LBCS is arranged in the M6 layer. The LBCS extends in the Y direction, in parallel with the further LBCSs (not-shown) associated with the other local blocks of the sub-array 10. The LBRS extends in the X direction the M7 layer. The LBRSs extends in the X direction, in parallel with the further LBRSs (not shown) associated with the other local blocks of the sub-array 10. The M6 and M7 layers may as shown further comprise a "local-block-to-local-word line" line (LBLWL) and a "local block-to-switch" line (LBTG, where "TG" is used as the switches 1421, 1422 in the illustrated example are transmission gates). The LBLWL extends in the Y direction, in parallel to the LBCS. The LBTG extends in the X direction, in parallel to the LBRS. The functions of the LBLWL and LBTG is discussed below.

Referring again to Fig. 4d, the AND LB block corresponds to the first logic gate 1441, while the AND 0-7 blocks correspond to the second logic gates 1442. In the illustrated example, each circuit cell is an AND gate but may also be a NAND gate, as discussed above.

The first and second inputs of the first logic gate 1441 are connected to the LBCS in the M6 layer and the LBRS in the M7 layer. These connections may be realized by respective multi-level via structures extending through each intermediate interconnect layer, e.g., the Vx and Mx layers, where x = 2 to 6 for the LBCS and x = 2 to 7 for the LBRS.

The term "via structure" is here used to refer to any conductive element configured for vertical signal routing through the interconnect structure 6. Where a via structure is to interconnect two consecutive routing layers (e.g., Mx and Mx+1), the via structure may be a single-level via (e.g., a via of a single Vx layer). Where a via structure is to interconnect non-consecutive routing layers the via structure may be a multi-level via structure comprising one or more via portions and one or more line segments (e.g., "metal islands") of the one or more via and routing layers through which the multi-level via structure extends. A multi-level via structure may also comprise, or be formed as, a so-called "supervia", i.e., a via with a height of two or more routing levels. It is to be understood that when elements (e.g., a contact and a line, two lines, etc.) which are offset relative to one another along the X- and/or Y-directions are to be interconnected by a multi-level via structure, such offset may be accommodated for by one or more correspondingly oriented line segments of the multi-level via structure (e.g., a line segment extending in the X direction and/or a line segment extending in the Y direction), to reach the position within the XY plane needed to establish the intended vertical connection. Hence, a multi-level via structure is not limited to merely a "straight-line" vertical signal routing.

Still with reference to Fig. 4d, the first input of each second logic gate 1442 is connected to a respective one of the GWLs of the M5 layer and its output is connected to the corresponding LWL of the M1 layer (e.g., which is overlapped by the respective GWL). In the illustrated example, AND 0 is connected to LWL₀ and GWL₀, AND 1 is connected to LWL₁ and GWL₁, and so on. The connection between a second logic gate 1442 and its associated GWL may be realized by a multi-level via structure extending between the M5 layer and the Active 2 layer. The connection between a second logic gate 1442 and its associated LWL may be realized by a via structure extending between the M1 layer and the Active 2 layer. The via structure may be a single-level via of the BS via layer. Where the additional M2a layer is present, the via structure may be a multi-level via structure comprising a via portion in the BS via layer, a line segment in the M2a layer and a via portion in the V2a layer.

The second input of each second logic gate 1442 is connected to the output LB0 of the first logic gate 1441. This connection may be realized by connecting the output LB0 and the second input of each second logic gate 1442 to the LBLWL of the M6 layer using respective multi-level via structures. The signal from the output LB0 may hence be routed to the respective second inputs of the second logic gates 1442 via a dedicated line in the M6 layer.

Still with reference to Fig. 4d, the "TG" blocks correspond to the first and second switches 1441, 1442. In the illustrated example, each switch is a transmission gate but other types of switches are also possible, as discussed above.

The connection between each first switch 1421 and its associated LBL in the M0 layer may be realized by a first multi-level via structure extending between the Active 2 layer and the M0 layer. The connection between each first switch 1421 and its associated GBL in the M4 layer may be realized by a second multi-level via structure extending between the Active 2 layer and the M4 layer. Correspondingly, the connection between each second switch 1422 and its associated LBLB in the M0 layer may be realized by a third multi-level via structure corresponding to the first multi-level via structure. Similarly, the connection between each second switch 1422 and its associated GBLB in the M4 layer may be realized by a fourth multi-level via structure corresponding to the second multi-level via structure.

The control input of each switch 1421, 1422 is connected to the output LB0 of the first logic gate 1441. This connection may be realized by connecting the output LB0 and the control inputs of each switch 1421, 1422 to the LBTG of the M7 layer using respective multi-level via structures. The signal from the output LB0 may hence be routed to the respective control inputs of the switches 1421, 1422 via a dedicated line in the M7 layer.

Various layout options for the logic gates 1441, 1422 and switches 1421, 1422 are possible. Fig. 4d shows one example. Each logic gate 1441, 1422 and switch 1421, 1422 defines (i.e., is arranged in) a respective circuit cell of a plurality of non-overlapping circuit cells of the Active 2 layer.

The switches 1421, 1422 (e.g., TG LBL0, TG LBLB0, TG LBL 1, TG LBLB 1, etc.) define a first subset of circuit cells. The first subset of circuit cells are arranged in two (2) cell rows and a number of cell columns corresponding to the number local columns of the local block 120 (m+1 in the illustrated example).

The second logic gates 1442 (AND 0-7 blocks) define a second subset of circuit cells, non-overlapping with the first subset of circuit cells. In Fig. 4d, only the circuit cells of the first subset comprising the AND 0-7 blocks are visible, but the first subset comprises a circuit cell for each of the second logic gates 1442 (n+1 in the illustrated example). The second subset of circuit cells are arranged in a plurality of cell rows.

The circuit cell of the first logic gate 1441 (AND LB) is a further circuit cell, not forming part of the first and second subsets of circuit cells, and arranged in a further cell row, different from the cell rows of the first and second subsets of circuit cells.

A width dimension of each circuit cell ("first cell dimension") of the plurality of circuit cells of the Active 2 layer is oriented along the Y direction. As may be appreciated by the skilled person, this may imply that a channel direction of the backend transistors of the circuit cells extend in parallel in the Y direction, and the gates of the backend transistors extend in parallel in the X direction. The circuit cells have a same cell width. In other words, the circuit cells (and hence the cell rows) have a substantially uniform cell width. In the illustrated example, the cell width of the circuit cells corresponds to two times a cell width of the bit cells of the local block 120 ("a first cell dimension" of the bit cells). Hence, each cell row is aligned with / overlaps a respective pair of local rows of bit cells of the local block 120. For example, the first cell row of the second subset of circuit cells (AND 0-3) is aligned with local rows 0 and 1, and the second cell row of the second subset of circuit cells (AND 4-7) overlap local rows 2 and 3. The cell width also corresponds to two times the pitch of the LWLs or GWLs. This applies correspondingly to the relationship between the cell rows and the LWLs and GWLs. Hence, each cell row aligns with / is overlapped by a respective pair of LWLs and GWLs.

In the illustrated example, each cell row of the second subset of circuit cells comprises a respective group of four consecutive circuit cells of second logic gates 1422. This arrangement reduces the space along the Y direction allocated by the second logic gates 1422. That is, the number of cell rows needed to accommodate the second logic gates 1422 may be less than the total number of second logic gates 1422 (which is equal to the number of LWLs or GWLs). This allows the second logic gates 1422 to fit within the Y dimension of the local block 120, although the cell width of the circuit cells is greater than the pitch of the LWLs and GWLs. With four circuit cells (second logic gates 1422) per cell row, the second logic gates 1422 may be accommodated within (n+1)/4 cell rows. As may be appreciated, a similar effect may be achieved also for other numbers of circuit cells per cell row. For instance, a greater number of circuit cells in each cell row further reduces the number of cell rows needed to accommodate the second logic gates 1422. Also cell rows of non-uniform length are possible, meaning that cell rows may comprise different numbers of second logic gates 1422. A general condition to reduce the number of cell rows of second logic gates 1422 below the total number of second logic gates 1422, is that at least one cell row of the second subset of circuit cells comprises two or more second logic gates 1422. However, including two or more second logic gates 1422 in each cell row may contribute to a more regular layout of the Active 2 layer, especially if each cell row comprises a same number of second logic gates 1422.

Still with reference to the second subset of cell rows, the respective groups of cells of each cell row are further offset with respect to each other along the X direction such that each second logic gate 1422 is arranged at a respective (i.e., different) position along the X direction. This may reduce the routing complexity associated with the connections between the second logic gates 1422 and the LWLs/GWLs (which extend in the X direction), since each connection between a second logic gate 1422 and its associated LWL may be provided along a straight line horizontal path along the Y direction (e.g., using a respective routing track of the optional M2a layer discussed above) while avoiding a situation where a connection between one second logic gate 1422 and its associated LWL would "block" a connection between another second logic gate 1422 and its associated LWL.

A further effect of the above-discussed arrangement of the second logic gates 1422 is that space is created for accommodating the first subset of cell rows of the switches 1421, 1422 (TGs) within the footprint of the local block 120.

As shown in Fig. 4d, the first switches 1421 and the second switches 1422 are arranged in the first cell row and the second cell row, respectively, of the first subset of circuit cells. Thus, each cell column comprises a first cell comprising a first switch 1421 and a second cell comprising a second switch 1422.

The first subset of circuit cells each have a cell height ("second cell dimension") along the X direction corresponding to (i.e., substantially equal to) a cell height of the bit cells of the local block 120 ("a second cell dimension" of the bit cells). This allows the switches 1421, 1422 to fit within the X dimension of the local block 120.

Each cell column of the first subset of circuit cells is further aligned with / overlaps a respective local column of the local block 120. More specifically, each cell column is aligned with the local column of bit cells and the pair of LBL/LBLBs and GBL/GBLBs associated with the local column. That is, the cell column of TG LBL0 and TG LBLB0 is aligned with LBL0/LBLB0 and GBL0/GBLB0, the cell column of TG LBL1 and TG LBLB1 is aligned with LBL1/LBLB1 and GBL1/GBLB1, and so on. This facilitates the signal routing between the LBLs, the first switches 1421 and the GBLs, and between the LBLBs, the second switches 1422 and the GBLBs, respectively.

As mentioned above, Fig. 4d shows one layout option for the logic gates 1441, 1422 and switches 1421, 1422, however other layouts are possible. In addition to the variations already mentioned above, different width-to-width relationships between the circuit cells and the bit cells than 2:1 may be used, wherein other relationships between the number of cell rows of the second subset of circuit cells may apply. For example, a greater width-to-width ratio than 2:1 may necessitate a greater number of second logic gates 1442 in each cell row to not exceed the Y dimension of the footprint of the local block 120, and to provide sufficient space for the first subset of circuit cells of the switches 1421, 1422.

Moreover, each group of second logic gates 1442 need not necessarily be arranged as consecutive cells of a cell row, but may be spaced apart (e.g., by one or more "empty" circuit cells of the cell row) along the X direction.

Moreover, the first logic gate 1441 (AND LB) need not necessarily be arranged in a different cell row than the second logic gates 1442, but may more generally be arranged in an un-allocated cell of same cell row as a group of second logic gates 1442, as an example.

Moreover, while in Fig. 4d, the first subset of circuit cells are arranged along the bottom most local rows of the local block 120 and the second subset of circuit cells are arranged along the top most local rows of the local block 120, an opposite arrangement is also possible. It is further contemplated that the first and second cell rows of the first subset of circuit cells need not be neighboring (i.e., adjoining) cell rows.

The interconnect layers of the interconnect structure 6 may, like typical BEOL interconnect structures, use different pitches ( "metal pitch"). For instance, the M0 layer of the interconnect structure 6 may have a smaller metal pitch than the M2 layer. Also the M1 layer may have a smaller metal pitch than the M2 layer. In the illustrated example the M2 layer is the first (bottom-most) routing layer over the Active 2 layer. This implies that the circuit cells of the Active 2 layer may have relaxed pitch compared to the metal pitch of the bit cells of the Active 1 layer (for which the M0 layer is the first routing layer). Forming the Active 2 layer at a relaxed pitch may reduce fabrication complexity and costs. However, it is also possible to form the M2 layer with a same pitch as the M0 layer (and the M3 layer with a same pitch as the M1 layer) to allow fabrication of the circuit cells of the Active 2 layer with a smaller cell height. In implementations where the M2a layer is present, the M2a layer and the M2 layer may typically have a same pitch.

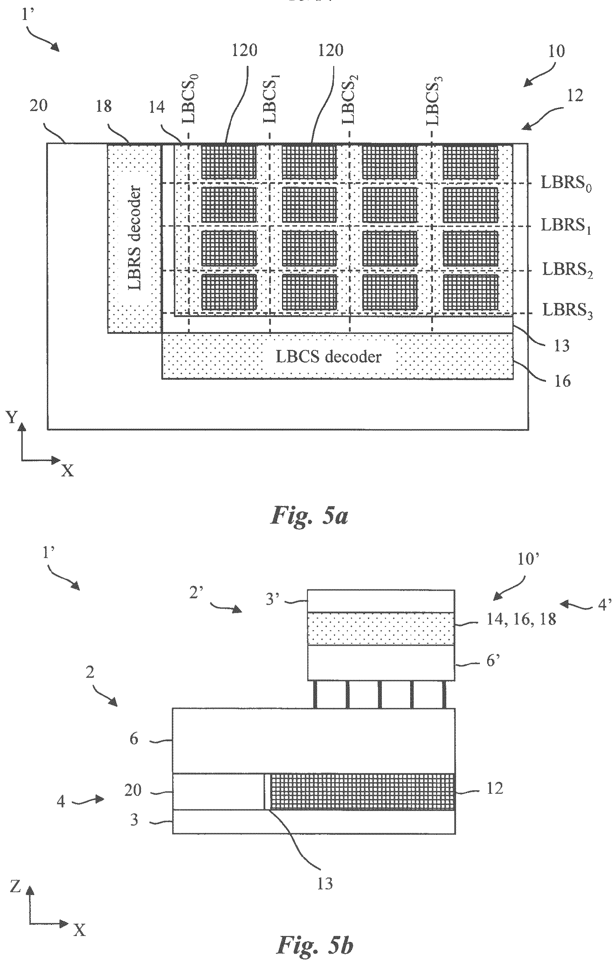

Fig. 5a-b schematically depict a top-down view (Fig. 5a) and a side view (Fig. 5b) of an SRAM device 1' according to another example implementation. Fig. 1a-b and 5a-b use like reference signs to refer to like elements and reference is therefore made to the above for a detailed discussion of such elements, to avoid undue repetition. Rather, the following discussion will mainly focus on differences between the SRAM devices 1 and 1'.

The SRAM device 1' comprises in addition to the die 2 (which here is denoted "first die 2") comprising the bit cell array 12, a second die 2' stacked and bonded with the die 2. The second die 2' comprises as shown a second FEOL structure 4' and a second BEOL interconnect structure 6'. The second die 2' may like the second die 2 be a conventional semiconductor die or substrate, suitable for CMOS circuits and semiconductor device processing. The second die 2' may as shown comprise a substrate 3', for instance a semiconductor substrate of Si (or any of the further examples mentioned for the substrate 3).

The SRAM device 1' comprises like the SRAM device 1 a sub-array 10' implementing a divided design. However, in the sub-array 10' the additional logic 14 of the divided design is instead implemented by the second die 2'. More specifically, the transistors of the additional logic 14 of the sub-array 10' are implemented as frontend transistors arranged in the second FEOL structure 4' (e.g., NMOSFETs and PMOSFETs, horizontal channel FETs, having channel regions and S/D regions formed on or in an active layer of the die 2', etc.). Hence, the transistors of the bit cells of the bit cell array 12 (the first set of transistors) and the transistors of the additional logic 14 (the second set of transistors) may each be implemented as frontend transistors, however arranged in FEOL structures of different dies, that is the first FEOL structure 4 of the first die 2 and the second FEOL structure 4' of the second die 2', respectively.

As indicated by the vertically oriented lines in Fig. 5b extending between the first and second dies 2, 2', the additional logic 14 may be connected to the bit cell array 12 via the interconnect structures 6, 6' of the respective dies 2, 2'. The first and second dies 2, 2' are in the illustrated example bonded face-to-face, i.e., with the first interconnect structure 6 of the first die 2 facing the second interconnect structure 6' of the second die 2'. The die-to-die interconnection may hence be realized by interconnects (e.g., vias and/or lines) arranged in a top portion or layer of the respective interconnect structures 6, 6', or in a combined bonding and interconnect layer structure arranged between the interconnect structures 6, 6'.

The bit cell array 12 and the second die 2' may as shown be arranged to overlap, such that the second die 2' is located within the footprint of the bit cell array 12. This may facilitate signal routing between the dies 2, 2'. It may also reduce the routing overhead associated with the additional logic 14, by limiting the amount of horizontal routing resources needed for interconnecting the additional logic 14 and the bit cell array 12. In the illustrated example the second die 2' is shown to be fully accommodated within the footprint of the bit cell array 12. However, this is merely one example and implementations wherein the second die 2' extends outside the footprint of the bit cell array 12 are also possible.

To further facilitate signal routing and limit routing overhead, the respective frontend transistors of the additional logic 14 associated with each local block 120 of the bit cell array 12 may be arranged within the footprint of its associated local block 120. This is however not a requirement and the provision of the additional logic 14 in the second die 2' may allow for a more flexible layout of the additional logic, relative the common-die implementation of the SRAM device 1.

In any case, the distribution of the various lines of the sub-array 10' may be as follows: The first interconnect structure 6 of the first die 2 may comprise the LWLs of the HWLs, and the LBLs and LBLBs of the HBLs. Meanwhile, the second interconnect structure 6' of the second die 2' may comprise the GWLs of the HWLs, the GBLs and GBLBs of the HBLs and the LBCSs and LBRSs. The second interconnect structure 6' may further comprise the above-discussed interconnects for the logic circuits and switches associated with each local block (e.g., LBLWL connecting the output of the first AND gate 1441 to second AND gates 1442, and LBTG connecting the output of the first AND gate 1441 to the control inputs of the TGs 1421, 1422).

The sub-array 10' further comprises an LBCS decoder 16 and an LBRS decoder 18. In contrast to the sub-array 10, the LBCS and LBRS decoders 16, 18 are here as shown comprised in the second die 2'. Hence, the transistors of the peripheral logic (the third set of transistors) of the divided design are implemented as frontend transistors arranged in the second FEOL structure 4'. The third set of transistors may like the frontend transistors of the bit cells (first set of transistors) and the additional logic 14 (second set of transistors) be NMOSFETs and PMOSFETs, and be implemented in a corresponding manner. The peripheral logic may for instance be arranged in a peripheral region to the additional logic 14. However, it is also possible to implement the peripheral logic and the additional logic 14 in an interleaved manner within a common footprint of the second die 2'.

As further shown in Fig. 5a-b, the sub-array 10', like the sub-array 10, may further comprise peripheral logic 20 not related specifically to the divided design, such as a word line decoder, write drivers, precharge circuitry, sense amplifiers, etc.

While Fig. 5a-b shows a single sub-array 10', the die-stack based implementation of the SRAM device 1' is also compatible with plural sub-arrays. In an implementation wherein the SRAM device 1' comprises a plurality of sub-arrays, it is contemplated that respective additional logic of each of a plurality of sub-arrays (each corresponding to the die 2') may be implemented in a common second die. For instance, the additional logic of each sub-array may be arranged to overlap with and be connected to the bit cell array of its associated sub-array. However, it is also possible to provide a second die for each sub-array. For example, a plurality of second dies (each corresponding to the die 2') may be stacked on and bonded to the first die such that each second die overlaps and is connected to the bit cell array of its associated sub-array.

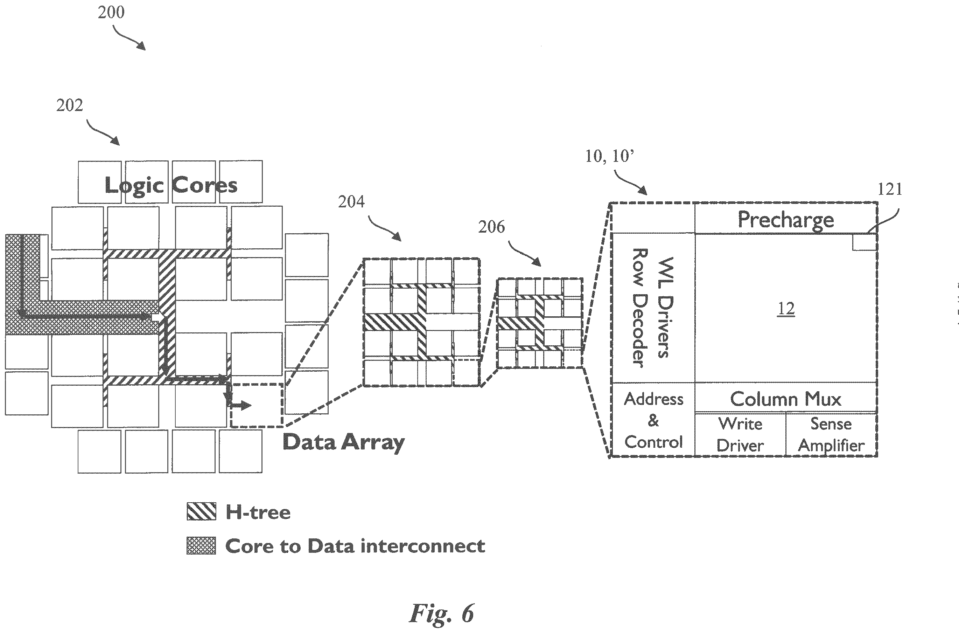

As mentioned above, the sub-arrays 10, 10' shown in Fig. 1a-b and 5a-b may be one of a a plurality of correspondingly configured sub-arrays of SRAM devices 1, 1'. The block diagram in Fig. 6 shows an example of an SRAM device 200 comprising a plurality of sub-arrays, each corresponding to sub-array 10 or 10'. More specifically, the SRAM device 200 comprises an SRAM macro 202. The macro 202 comprises as shown a data array comprising a plurality of banks 204, a set of logic cores and an H-tree and center pin configured to connect the logic cores to the banks 204. Each bank 204 comprises in turn a plurality of sub-banks or "mats" 206. Each mat 206 comprises in turn a plurality of sub-arrays 10, 10'. The mats 206 and the sub-arrays 10, 10' may, like the banks 204, be interconnected by respective H-trees in a center pin configuration. It is to be noted that Fig. 6 merely is one example of how a plurality of sub-arrays may be logically arranged in an SRAM device, and that the present disclosure is applicable also to other logical arrangements, such as an SRAM device comprising a single bank comprising a plurality of sub-arrays 10, 10', as one nonlimiting example.

The person skilled in the art realizes that the present invention by no means is limited to the examples described above. On the contrary, many modifications and variations are possible within the scope of the appended claims. For instance, while in the above illustrated example of Fig. 4a-g, the Active 2 layer is arranged between the M1 and M2 layers, or, where present, between the M2a and M2 layers, the Active 2 layer may also arranged at a lower or higher level in the BEOL structure 6. In general, the Active 2 layer may be arranged at any level within the BEOL structure 6 as long as sufficient horizontal routing resources are available below and above, to realize the necessary interconnections with the further circuitry of the sub-array 10. Moreover, while in the above the backend transistors of the additional logic 14 / Active 2 layer are arranged in a same device tier (i.e., layer) of the BEOL structure 6, it is contemplated that the backend transistors may be arranged in more than one device tier. For instance, the backend transistors of the logic circuit 144 and the backend transistors of the switches 1421, 1422 may be arranged in two different device tiers of the BEOL structure 6, e.g., in the Active 2 layer and in a further active layer ("Active 3").

## Claims

1. An SRAM device (1) comprising:
a plurality of hierarchical word line structures, HWLs, each comprising a global word line, GWL, and a plurality of local word lines, LWLs;
a plurality of hierarchical bit line structures, HBLs, each comprising a global bit line, GBL, a plurality of local bit lines, LBLs, a global bit line bar, GBLB, and a plurality of local bit line bars, LBLBs;
a plurality of local block column select lines, LBCSs;
a plurality of local block row select lines, LBRSs; and
an SRAM bit cell array (12) comprising a plurality of bit cells (121) arranged in a plurality of array rows and array columns, each array row associated with a respective HWL and each array column associated with a respective HBL,
wherein the SRAM bit cell array (12) is partitioned into a plurality of local blocks (120), each local block associated with a respective LBCS and LBRS, and each comprising a respective subset of bit cells arranged in a plurality of local rows and local columns, each local row comprised in one of the array rows and connected to a respective LWL of the HWL associated with the array row, each local column comprised in one of the array columns and connected to a respective LBL and LBLB of the HBL associated with the array column;
for each local column of each local block (120), a first switch (1421) and a second switch (1422), the first switch configured to selectively connect the LBL connected to the local column to its associated GBL, and the second switch configured to selectively connect the LBLB connected to the local column to its associated GBLB; and
for each local block (120), a respective logic circuit (144) configured to individually assert a LWL connected to a local row of the local block in response to the LBCS and LBRS associated with the local block, and the GWL associated with the LWL being simultaneously asserted;
wherein each bit cell (121) comprises cross-coupled inverters (PU1/PD1, PU2/PD2) and pass gates (PG1, PG2), the inverters and pass gates comprising a first set of transistors arranged in a front-end-of-line, FEOL, structure (4) of a die (2) of the SRAM device (1); and
wherein the first and second switches (1421, 1422) and the logic circuits (144) comprise a second set of transistors arranged in one or more device tiers (14) over the FEOL structure (4).

2. The SRAM device according to claim 1, wherein the logic circuit (144) associated with each local block (120) comprises:
a first logic gate (1441) having a first input connected to the associated LBCS and a second input connected to the associated LBRS, and,
for each LWL connected to a local row of the local block, a second logic gate (1442) having a first input connected to the GWL associated with the LWL, a second input connected to an output of the first logic gate, and an output connected to the LWL,
wherein each of the first and second logic gates is an AND gate or a NAND gate.

3. The SRAM device according to claim 2, wherein each first and second logic gate (1441, 1422) and first and second switch (1421, 1422) is arranged in a respective circuit cell of a plurality of circuit cells of the one or more device tiers (14), overlapping the local block (120),
wherein the first and second switches (1421, 1422) are arranged in a first subset of circuit cells, the first subset of circuit cells arranged in two cell rows and a number of cell columns corresponding to the number of local columns of the local block (120), and
wherein the second logic gates (1422) are arranged in a second subset of circuit cells, the second subset of circuit cells arranged in a number of cell rows, wherein at least one of the cell rows of the second subset comprises more than one second logic gate (1422) such that the number of cell rows of the second subset of circuit cells is less than the number of local rows of the local block (120).

4. The SRAM device according to any one of the preceding claims, wherein the first and second switch (1421, 1422) are configured to turn on in response to the LBCS and LBRS associated with the local block (120) being simultaneously asserted.

5. The SRAM device according to claim 4, when dependent on claim 2, wherein a respective control input of the first and second switch (1421, 1422) is connected to the output of the first logic gate (1441).

6. The SRAM device according to any one of the preceding claims, wherein each first and second switch comprises a transmission gate (1421, 1422).

7. The SRAM device according to any one of the preceding claims, wherein the second set of transistors is arranged within a footprint of the bit cells of the SRAM bit cell array (12).

8. The SRAM device according to any one of the preceding claims, further comprising peripheral logic comprising a LBCS decoder (16) configured to selectively assert the LBCSs and a LBRS decoder (18) configured to selectively assert the LBRSs, wherein the peripheral logic is implemented by a third set of transistors arranged in the FEOL structure (4) of the die (2), in a peripheral region to the SRAM bit cell array (12).

9. The SRAM device according to any one of the preceding claims, further comprising a back-end-of-line, BEOL, interconnect structure (6) arranged on the FEOL structure (4) and comprising the GWLs, LWLs, GBLs, LBLs, GBLBs, LBLBs, LBCSs and LBRSs, wherein the one or more device tiers comprising the second set of transistors are arranged in the BEOL interconnect structure (6).

10. The SRAM device according to claim 9, wherein the LWLs, LBLs and LBLBs are arranged below the one or more device tiers comprising the second set of transistors.

11. The SRAM device according to claim 10, wherein the GWLs, GBLs, GBLBs, LBCSs and LBRSs are arranged above the one more device tiers comprising the second set of transistors.

12. The SRAM device according to any one of claims 9-11, wherein the second set of transistors are thin-film transistors.

13. The SRAM device (1') according to any one of claims 1-8, wherein the die is a first die (2) and the FEOL structure is a first FEOL structure (4), and the SRAM device further comprises a second die (2') stacked on top of the first die and comprising a second FEOL structure (4'), wherein the second set of transistors are arranged in the second FEOL structure.

14. The SRAM device according to claim 13, further comprising:
a first BEOL interconnect structure (6) arranged on the first FEOL structure (4); and
a second BEOL interconnect structure (6') arranged on the second FEOL structure (4');
wherein the second die (2') is stacked on top of the first die (2), with the second BEOL structure (6') facing the first BEOL structure (6), and
wherein the first BEOL interconnect structure (6) comprises the LWLs, the LBLs and the LBLBs, and wherein the second BEOL interconnect structure (6') comprises the GWLs, GBLs, GBLBs, LBCSs and LBRSs.

15. The SRAM device (200) according to any one of the preceding claims, further comprising an SRAM macro (202), wherein the SRAM bit cell array (12) is comprised in one of a plurality of SRAM sub-arrays (10, 10') of the SRAM macro, each sub-array comprising:
a respective SRAM bit cell array configured in accordance with the SRAM bit cell array of the SRAM device of any one of the preceding claims;
a respective set of HWLs, HBLs, LCBSs and LBRSs configured in accordance with the set of HWLs, HBLs, LCBSs and LBRSs of the SRAM device of any one of the preceding claims; and
respective first and second switches and logic circuits configured in accordance with the first and second switches and the logic circuits, respectively, of the SRAM device according to any one of the preceding claims.
